# EUROPÄISCHE PATENTSCHRIFT

(11) **EP 2 558 843 B1**
(45) Veröffentlichungstag und Bekanntmachung des Hinweises auf die Patenterteilung: **29.08.2018**
(21) Anmeldenummer: 11714024.4
(22) Anmeldetag: 08.04.2011
(51) Int. Cl.: G01N 17/04

(54) **KORROSIONSDETEKTIONSVORRICHTUNG ZUR ÜBERWACHUNG EINES KORROSIONSZUSTANDES**
CORROSION DETECTION APPARATUS FOR MONITORING A STATE OF CORROSION
DISPOSITIF DE DÉTECTION DE CORROSION POUR SURVEILLER UN ÉTAT DE CORROSION

(30) Priorität: 14.04.2010 DE 102010014918
(43) Veröffentlichungstag der Anmeldung: 20.02.2013
(73) Patentinhaber: Airbus Defence and Space GmbH, 82024 Taufkirchen (DE)
(72) Erfinder: STEINWANDEL, Jürgen, 88690 Uhldingen-Mühlhofen (DE); HECKENBERGER, Ulrike, 81669 München (DE); HACK, Theo, 85635 Höhenkirchen-Siegertsbrunn (DE)
(74) Vertreter: Isarpatent
(86) Internationale Anmeldenummer: PCT/EP2011/055538
(87) Internationale Veröffentlichungsnummer: WO 2011/128271

(56) Entgegenhaltungen:
- WO-A2-2009/016594
- JP-A- 7 113 740
- US-A1- 2006 125 493
- US-A1- 2009 058 427
- US-A1- 2009 162 076
- SIMONEN J T ET AL: "Wireless sensors for monitoring corrosion in reinforced concrete members", PROCEEDINGS OF THE SPIE - THE INTERNATIONAL SOCIETY FOR OPTICAL ENGINEERING SPIE-INT. SOC. OPT. ENG. USA, Bd. 5391, Nr. 1, 2004, Seiten 587-596, XP002640210, ISSN: 0277-786X

## Beschreibung

### GEBIET DER ERFINDUNG

Die Erfindung betrifft den Nachweis von Korrosion an Bauteilen oder von korrosiven Umgebungsbedingungen. Insbesondere betrifft die Erfindung eine Korrosionsdetektionsvorrichtung zur permanenten und integralen Überwachung eines Korrosionszustandes eines Bauteils, sowie ein Luftfahrzeug mit einer solchen Korrosionsdetektionsvorrichtung.

### TECHNOLOGISCHER HINTERGRUND

Aufgrund der langen Betriebsdauer von Fahrzeugen, die beispielsweise im Falle von Flugzeugen 30 Jahre betragen kann, ist der Schutz metallischer Bauteile gegenüber Korrosion von besonderer Bedeutung. Einen Großteil der in der Luftfahrzeugindustrie verbauten Materialien machen Aluminiumlegierungen aus. Insbesondere an Stellen, die einer direkten visuellen Inspektion nicht oder nur unter erheblichem Aufwand zugänglich sind und von welchen bekannt ist, dass Wasserbeaufschlagung oder auch Elektrolytbeaufschlagung in größerem Umfang möglich sind, sollten regelmäßige Intervalle zur Korrosionsüberprüfung eingehalten werden.

Sowohl zivile Luftfahrzeuge als auch militärische Transporter verkehren in mehr oder weniger regelmäßigen Abständen in Klimazonen mit sehr hoher Luftfeuchtigkeit und hoher Umgebungstemperatur wie maritimen Atmosphären, so dass sich Kondensationswasser bilden kann.

Es ist bekannt, mittels Feuchtesensoren, die mit einer wassersensitiven Schicht versehen sind, eine momentane Feuchtigkeit zu detektieren. Diese Sensoren sind in der Regel als Dünnschichtsysteme ausgeführt und arbeiten reversibel, in Abhängigkeit des jeweils äußeren momentanen H₂O-Partialdrucks. Die reversible Aufnahme von Wasser in die sensitive Schicht auf oder in den Kondensator verursacht eine Änderung der Kapazität, welche Änderung die Messgröße in diesen Sensoren darstellt. Jedoch können derartige Sensoren eine integrale H₂O-Aufnahme oder Elektrolytaufnahme nicht direkt bestimmen.

Die Druckschriften US 2009/058427 A1, WO 2009/103302 A1, DE 10 2006 030 519 A1, US 5 243 298 A, US 2007/163892 A1, US 2008/204275 A1 und US 5286 357 A befassen sich dabei mit Messtechnik bezüglich Korrosion ZUSAMMENFASSUNG DER ERFINDUNG Es kann als eine Aufgabe der Erfindung angesehen werden, eine verbesserte Korrosionsdetektion bereitzustellen.

Es sind eine Korrosionsdetektionsvorrichtung zur permanenten und integralen Überwachung eines Korrosionszustandes eines Bauteils oder zur Detektion von korrosiven Umgebungsbedingungen, sowie ein Luftfahrzeug mit einer Korrosionsdetektionsvorrichtung gemäß den Merkmalen der unabhängigen Ansprüche angegeben. Weiterbildungen der Erfindung ergeben sich aus den Unteransprüchen.

Die beschriebenen Ausführungsbeispiele betreffen gleichermaßen die Korrosionsdetektionsvorrichtung und das damit ausgestattete Luftfahrzeug. Mit anderen Worten können Merkmale, die im Folgenden in Bezug auf die Korrosionsdetektionsvorrichtung beschrieben werden genauso auch in eine Korrosionsdetektionsvorrichtung im Luftfahrzeug implementiert sein, und umgekehrt.

Gemäß der Erfindung ist eine Korrosionsdetektionsvorrichtung zur permanenten und integralen Überwachung eines Korrosionszustandes eines Bauteils oder der Korrosivität der Umgebungsbedingungen angegeben. Dabei weist die Korrosionsdetektionsvorrichtung eine Sensorikschaltung zur Detektion von Korrosion an dem Bauteil auf, wobei die Sensorikschaltung einen ersten elektrischen Leitungsabschnitt und einen zweiten Leitungsabschnitt aufweist. Weiterhin weist die Sensorikschaltung ein korrosionssensitives Überbrückungselement mit einem ersten Ende und einem zweiten Ende auf, wobei das erste Ende mit dem ersten Leitungsabschnitt und das zweite Ende mit dem zweiten Leitungsabschnitt in einem Ausgangszustand in elektrisch leitender Verbindung steht. Dabei weist das korrosionssensitive Überbrückungselement in dem Ausgangszustand eine erste elektrische Leitfähigkeit und in einem Korrosionszustand eine zweite elektrische Leitfähigkeit derart auf, dass mit der Sensorikschaltung auf Basis eines Wechsels von der ersten zur zweiten elektrischen Leitfähigkeit Korrosion detektierbar ist, dadurch gekennzeichnet dass der erste elektrische Leitungsabschnitt als eine erste Elektrode (109) eines Kondensators (110) und der zweite elektrische Leitungsabschnitt als eine zweite Elektrode (111) des Kondensators ausgeführt ist,wobei der Kondensator ein Interdigitalkondensator (112) ist,wobei das korrosionssensitive Überbrückungselement als Dünnschicht (104) zwischen zwei Elektroden des Interdigitalkondensators ausgeführt ist, und wobei der Interdigitalkondensator im Ausgangszustand durch das korrosionssensitive Überbrückungselement kurzgeschlossen ist.

Dabei ist die "permanente und integrale Überwachung" im Gegensatz zu momentanen Feuchtigkeitsmessungen zu sehen. Mit anderen Worten wird mittels der Erfindung ermöglicht, dass die gesamte Umgebung, die korrosionsverursachend seit Einbau der Korrosionsdetektionsvorrichtung eingewirkt hat berücksichtigt beziehungsweise gemessen wird.

Dies kann eine Sicherheitserhöhung beispielsweise im Flugverkehr bedeuten. Es wird damit eine verlässliche Messung des Korrosionszustandes an Stellen eines Bauteils oder Gegenstandes ermöglicht, der schwer zugänglich ist. Über elektrische Leitungen können die Messergebnisse der Korrosionsdetektionsvorrichtung zum Beispiel an zentrale Rechenstellen gegeben werden, wo sie einem Benutzer leichter zugänglich sind.

Weiterhin soll in diesem und jedem anderen Ausführungsbeispiel der Erfindung der Begriff "korrosionssensitiv" wie folgt verstanden werden: Das Überbrückungselement ändert seinen physischen Zustand und damit seine elektrische Leitfähigkeit durch Korrosion auf einer Zeitskala, die kürzer ist als die Einsatzdauer des zu überwachenden Bauteils ist. Somit kann der erfindungsgemäße Nachweis der Korrosion an dem Bauteil noch während seines Einsatzes nachgewiesen werden.

Dabei kann das korrosionssensitive Überbrückungselement die gleiche Sensitivität bzw. Empfindlichkeit hinsichtlich Korrosion wie das zu überprüfende Bauteil aufweisen. Dies kann beispielsweise durch das gleiche Material erreicht werden, aus dem die beiden Bauteile bestehen. Aber auch eine davon abweichende Sensitivität ist möglich.

Aufgrund des korrodierten Zustandes des Überbrückungselements kann anschließend in angegebener Weise eine Korrosion an dem Überbrückungselement und damit an dem Bauteil detektiert werden.

Mit anderen Worten stellt das korrosionssensitive Überbrückungselement eine elektrische Verbindung dar, welche mittels Korrosion rückgängig gemacht und damit unterbrochen werden kann. Diese korrosionsbedingte Verbindungstrennung kann anschließend mittels der Sensorikschaltung nachgewiesen werden.

Beispielsweise kann ein zuvor überbrückter Kondensator nun in einem Wechselstromkreis ausgelesen und dessen Kapazität bestimmt werden. Dies ist jedoch im Anfangszustand mit einem unkorrodierten Überbrückungselement nicht möglich. Jedoch ist es zusätzlich auch möglich, ein anderes Element der Sensorikschaltung mittels des Überbrückungselements zu überbrücken, wie beispielsweise eine Spule oder auch Leiterbahnen der Sensorikschaltung, die zur Bereitstellung einer elektrischen Spannung an der Sensorikschaltung enthalten sein können.

Mit anderen Worten ist die Sensorikschaltung derart ausgeführt, dass sie eine Messung elektrischer Eigenschaften einer Kombination aus dem ersten Leitungsabschnitt, dem zweiten Leitungsabschnitt und dem korrosionssensitiven Überbrückungselement ermöglicht.

Somit ist die Sensorikschaltung derart ausgeführt, dass bei der Durchführung einer Messung der elektrischen Eigenschaften dieser Kombination, das Ergebnis dieser Messung eindeutig die Frage beantwortet, ob Korrosion in der Korrosionsdetektionsvorrichtung und damit an dem zu überwachenden Bauteil stattgefunden hat. Wobei die elektrische Eigenschaft beispielsweise die Kapazität eines Kondensators, die Dämpfung eines Schwingkreises, die Amplitude eines Schwingkreises und/oder die Frequenz eines Schwingkreises sein kann.

Mit anderen Worten ist mittels der angegebenen Korrosionsdetektionsvorrichtung ein Sensor bereitgestellt, welcher in direkter Art und Weise eine integrale Wasseraufnahme und/oder Wassereinwirkung oder des zu überwachenden Bauteils ermöglicht. Ebenso ist dies hinsichtlich der Elektrolytaufnahmme und/oder Elektrolyteinwirkung möglich. Insbesondere an Stellen, die einer direkten visuellen Inspektion nicht oder nur unter erheblichem Aufwand an beispielsweise Luftfahrzeugen zugänglich sind und von welchen bekannt ist, dass die Wasserbeaufschlagung bzw. die Elektrolytbeaufschlagung in größerem Umfang möglich ist, kann eine kostengünstige und einfach zu produzierenden Vorrichtung angegeben werden, welche diese Messung ermöglicht.

Erfindungsgemäß wird das Überbrückungselement durch eine Dünnschicht bereitgestellt, welche im Laufe der Zeit auch unter Einwirkung von Korrosionseinflüssen korrodiert und damit eine elektrische Leitfähigkeit verändert. Diese Veränderung der elektrischen Leitfähigkeit kann mittels eines Auslesevorgangs der Sensorikschaltung dem Benutzer die Information geben, ob im Vergleich zu einem Referenzzustand Korrosion an dem Überbrückungselement bereits eingesetzt hat.

Dabei ist die erste elektrische Leitfähigkeit größer als die zweite elektrische Leitfähigkeit. Ebenso ist es möglich, dass das korrosionssensitive Überbrückungselement hinsichtlich seines Materials, seiner Dicke, möglicher zusätzlicher Schichten korrosionsresistenter Lacke derart gewählt werden kann, dass in einem Teilbereich des Überbrückungselements eine vollständige durch Korrosion hervorgerufene Zerstörung stattfindet. Dadurch wird die elektrische Überbrückung zwischen dem ersten elektrischen Leitungsabschnitt und dem zweiten elektrischen Leitungsabschnitt unterbrochen. In diesem Fall kann die elektrische Leitfähigkeit auch den Wert 0 betragen.

Gemäß der Erfindung ist der erste elektrische Leitungsabschnitt als eine erste Elektrode eines Kondensators und der zweite elektrische Leitungsabschnitt als eine zweite Elektrode des Kondensators ausgeführt.

Mit anderen Worten enthält die Sensorikschaltung einen Kondensator, dessen beide Elektroden durch das korrosionssensitive Überbrückungselement kurzgeschlossen werden.

In dem kurzgeschlossenen Zustand, der auch als Anfangszustand bezeichnet wird, ist ein Auslesen der Kapazität dieses Kondensators der Sensorikschaltung nicht möglich. Im Korrosionszustand hingegen, nachdem Korrosionsprozesse das Überbrückungselement durchtrennt haben, kann die Kapazität des Kondensators in einem Wechselstromkreis ausgelesen werden.

Dabei kann die Korrosionsdetektionsvorrichtung die dazu nötigen elektrischen Komponenten des Wechselstromkreises wie beispielsweise eine Spannungsquelle enthalten. Es ist jedoch auch möglich, dass lediglich zwei elektronische Anschlüsse durch die Korrosionsdetektionsvorrichtung bereitgestellt werden, an welchen der Wechselstromkreis angeschlossen wird. Beispielsweise ist es möglich, ein Luftfahrzeug mit einer Vielzahl solcher Korrosionsdetektionsvorrichtungen an den gewünschten Stellen zu versehen, um anschließend, Vorrichtung für Vorrichtung, die jeweilige Sensorikschaltung auszulesen, um über den jeweiligen Korrosionszustand Information zu erhalten.

Jedoch ist es auch möglich, eine oder eine Vielzahl solcher Korrosionsdetektionsvorrichtungen in die Netzwerkverwaltung des entsprechenden Luftfahrzeuges zu integrieren, und die Korrosionsdetektionsvorrichtungen bzw. die jeweilige Sensorikschaltung dieser Vorrichtungen zentral und aus der Ferne auszulesen. Damit kann festgestellt werden, ob eine Veränderung der elektrischen Leitfähigkeit des korrosionssensitiven Überbrückungselements und damit Korrosion im zu überwachenden Bauteil eingesetzt hat.

Dabei ist ein Interdigitalkondensator als Kondensator in der Sensorikschaltung zu verwenden, welcher als im Wesentlichen rein kapazitives Element verwendet wird. Mit anderen Worten enthält die Sensorikschaltung zur Detektion von Korrosion an dem Bauteil einen Interdigitalkondensator, der den Vorteil geringer Herstellungskosten aufweist. Zusätzlich kann vorteilhafterweise damit auch die Korrosionsdetektionsvorrichtung in einer quasi zweidimensionalen Ausführungsform hergestellt werden. Durch die Möglichkeit, einen Interdigitalkondensator flach herzustellen, kann die Korrosionsdetektionsvorrichtung platzsparend bereitgestellt werden und kann beispielsweise an Oberflächen zum Beispiel von Flugzeugen angebracht werden, ohne dass diese durch Korrosionsdetektionsvorrichtung wesentlich erhöht wird. Eine vergleichsweise geringe Erhöhung des Luftwiderstandes kann als weiterer Vorteil angegeben werden.

Weiterhin ist es damit möglich, die Korrosionsdetektionsvorrichtung in Chipbauweise herzustellen, welche einen Interdigitalkondensator beinhaltet. Dieser wiederum kann mittels Aufdampfmethode oder auch mittels Siebdruck hergestellt werden. Die Herstellungskosten dafür sind vergleichsweise niedrig und die Verfahren dazu sind industriell einsetzbar.

Mit anderen Worten ist aufgrund der Vielzahl ineinandergreifender Finger des Kondensators innerhalb einer Ebene die Möglichkeit bereitgestellt, die dritte Dimension, die beispielsweise einen Plattenkondensator aufweist, einzusparen.

Ein weiterer Vorteil der Verwendung eines Interdigitalkondensators (IDK) kann darin bestehen, dass aufgrund des Aufbringens dieses IDKs auf einem zu überwachenden Bauteil sich daraufhin das inhomogene elektrische Feld des IDKs in das zu überwachende Material eindringt und dessen Zustand direkt die Kapazität des IDK mitbestimmt. Das Bauteil dient somit als Dielektrikum des IDK. Eine Veränderung des Korrosionszustandes des Bauteils lässt sich damit auf Grund der Änderung des Dielektrikums und damit als Änderung der Kapazität des IDK nachweisen.

Mit anderen Worten kann durch die Verwendung eines Interdigitalkondensators das hinsichtlich Korrosion zu überwachende Material einerseits mittels der Unterbrechung des korrosionssensitiven Überbrückungselements Korrosion festgestellt werden. Andererseits kann auch mittels einer darauffolgenden Kapazitätsmessung eines nicht mehr überbrückten Interdigitalkondensators eine Degradation eines Beschichtungssystems erfolgen.

Gemäß einem weiteren Ausführungsbeispiel der Erfindung ist die Dünnschicht aus dem gleichen Material wie das zu überwachende Bauteil.

Im Falle eines Luftfahrzeuges, welches zumeist aus Aluminiumlegierungen besteht, ist das korrosionssensitive Überbrückungselement, also beispielsweise die Dünnschicht, aus einer Aluminiumlegierung gebildet. Mit Hilfe dieses Ausführungsbeispiels ist es möglich, eine 1:1 Abbildung bereitzustellen, welche mittels der Messung an der Sensorikschaltung ein Ergebnis widerspiegelt, wie es auch hinsichtlich des Korrosionszustandes in dem zu überwachenden Bauteil vorliegt.

Dabei kann in diesem und in jedem anderen Ausführungsbeispiel das zu überwachende Bauteil ein integraler Bestandteil einer Primärstruktur des Luftfahrzeuges sein.

Es sei weiterhin darauf hingewiesen, dass der Einsatzort solcher Korrosionsdetektionsvorrichtungen sowohl im Frachtraum als auch innerhalb der Kabine eines Luftfahrzeuges beispielsweise eines Flugzeuges gewählt sein kann. Gemäß einem weiteren Ausführungsbeispiel der Erfindung weist die Korrosionsdetektionsvorrichtung weiterhin eine Auslesevorrichtung auf, wobei die Auslesevorrichtung zur Messung elektrischer Eigenschaften einer Kombination aus dem ersten Leitungsabschnitt, dem zweiten Leitungsabschnitt und dem korrosionssensitiven Überbrückungselement ausgeführt ist.

Dabei können elektrische Eigenschaften beispielsweise die Kapazität eines Kondensators, die Dämpfung eines Schwingkreises, die Amplitude und/oder die Frequenz eines Schwingkreises sein. Auch andere Eigenschaften, die gemessen werden können sind möglich.

Weiterhin ist es möglich, dass die Korrosionsdetektionsvorrichtung eine Vielzahl elektrischer Widerstände in Parallelschaltung aufweist, wobei hier beispielsweise unterschiedliche Widerstände verwendet werden können. Diese können dann unterschiedliche Korrosionssensitivitäten aufweisen.

Dabei kann die Auslesevorrichtung beispielsweise durch Anschlüsse für die Kapazität gegeben sein, die an einen Wechselstromkreis angeschlossen wird. Ebenso ist es möglich, dass der Wechselstromkreis auch vollständig in der Auslesevorrichtung vorhanden ist. Ebenso kann eine externe Vorrichtung wie beispielsweise ein RFID-Auslesegerät als Auslesevorrichtung im Sinne dieses Ausführungsbeispiels der Erfindung verstanden werden.

Gemäß einem weiteren Ausführungsbeispiel der Erfindung ist die Sensorikschaltung als RFID-Schwingkreis ausgeführt.

Gemäß diesem Ausführungsbeispiel der Erfindung ist es möglich, ein RFID-Schwingkreis mit oder ohne Energiequelle, das heißt einen aktiven oder einen passiven RFID-Schwingkreis bereitzustellen. Ebenso kann ein Speicher in dem RFID-Schwingkreis vorhanden sein, welcher einmal oder auch mehrfach beschreibbar ist.

Beispielsweise kann innerhalb eines RFID-Schwingkreises der Kurzschluss im Anfangszustand durch die Überbrückung des ersten Teils der Spule und des zweiten Teil erfolgen. Aufgrund dieser Überbrückung mit einem Draht bzw. mit einer Leiterbahn kann dieser RFID-Schwingkreis beispielsweise stark gedämpft, verstimmt oder in den aperiodischen Grenzfall gebracht werden.

Weiterhin ist es möglich, in einem RFID-Schwingkreis das korrosionssensitive Überbrückungselement über einen Leiterbahnwiderstand einzubringen. Dies kann beispielsweise ein einzelner ohmscher Widerstand sein. In diesem Fall ist der Schwingkreis aktiv und ändert seine Resonanzfrequenz und Dämpfung mit kontinuierlich zunehmendem Widerstand in Folge fortschreitender Korrosion an dem Überbrückungselement, dem Ohmschen Widerstand. Der Schwingkreis kann mit fortschreitender Korrosion letztlich deaktiviert werden, was sich in der Unmöglichkeit zeigt, mittels eines Auslesegerätes den RFID-Schwingkreis zu aktivieren und auszulesen.

Beispielsweise kann durch den elektrischen Kurzschluss eines Kondensators innerhalb eines RFID-Schwingkreises dieser in einen inaktiven Zustand versetzt werden, weshalb er sich mittels seines Auslesegerätes nicht auslesen lässt. Ist das korrosionssensitive Überbrückungselement jedoch durchkorrodiert und somit kein Kurzschluss mehr vorhanden, kann der Schwingkreis durch das Auslesegerät aktiviert und ausgelesen werden. Eine Detektion dieses Ausleseereignisses bedeutet somit für Benutzer, dass eine entsprechende Korrosion vorliegt.

Gemäß einem weiteren Ausführungsbeispiel der Erfindung weist der RFID-Schwingkreis eine Antenne zum Senden und Empfangen von elektromagnetischen Signalen und einen analogen Schaltkreis mit einer elektrischen Kapazität und einer elektrischen Induktivität auf. Weiterhin überbrückt das korrosionssensitive Überbrückungselement in dem Anfangszustand den RFID-Schwingkreis elektrisch. Gemäß einem weiteren Ausführungsbeispiel der Erfindung ist die Sensorikschaltung derart ausgeführt, dass ein Auslesen ermöglicht wird, das ausgewählt ist aus der Gruppe bestehend aus gegenphasiges Reflektieren des von einem Lesegerät eingestrahlten Feldes, Schwächen des von einem Lesegerät eingestrahlten Feldes, Auslesen mittels Lastenmodulation, und jede Kombination daraus.

Gemäß einem weiteren Ausführungsbeispiel der Erfindung weist die Sensorikschaltung eine Mehrzahl parallel geschalteter korrosionssensitiver Überbrückungselemente auf, welche Überbrückungselemente unterschiedliche Korrosionssensitivitäten aufweisen, wobei die Mehrzahl der parallel geschalteter korrosionssensitiver Überbrückungselemente derart zueinander dimensioniert sind, dass sie einer vorgebbaren Charakteristik eines Korrosionszeitverlaufs entsprechen.

Mit anderen Worten kann bei der Annahme durchschnittlicher Korrosionsbelastung eine Charakteristik der Detektionskurve über der Zeit durch den Benutzer vorgegeben werden. Dies kann zum Beispiel durch die Auswahl unterschiedlich korrosionsresistenter Widerstände erfolgen.

Beispielsweise kann ein solcher Verlauf derart gewählt werden, dass er eine große Steigung aufweist, so dass ein entsprechender Nachweis von Korrosion eindeutig ist. Dabei ist in diesen Ausführungen ein Kurvenverlauf beschrieben und zu Grunde gelegt, in welchem die Messgröße, welche zur Detektion der Korrosion herangezogen wird über der Zeit aufgetragen ist. Diese Messgröße könnte zum Beispiel die Eigenfrequenz eines Schwingkreises oder der Gesamtwiederstand dieser Parallelschaltung sein.

Beispielsweise kann mittels der Form oder Geometrie des Widerstandes, also beispielsweise mittels des Durchmessers, eine unterschiedliche Korrosionssensitivität der entsprechenden elektrischen Widerstände bereitgestellt werden. Aber auch der Einsatz unterschiedlicher Materialien ist möglich. Es können korrosionsresistente Lacke auch nur teilweise zum Einsatz kommen.

Mit diesem Ausführungsbeispiel kann ermöglicht werden, dass die verwendeten elektrischen, parallel geschalteten Widerstände unterschiedlich schnell ihre elektrische Leitfähigkeit wegen Korrosion verändern. Dabei könnte beispielsweise ein erster Korrosionszustand dadurch charakterisiert sein, dass im Vergleich zum Anfangszustand ein parallel geschalteter elektrischer Widerstand durch Korrosion zerstört wurde. Gemäß den physikalischen Regeln der elektrischen Parallelschaltung würde sich dadurch der Gesamtwiderstand dieser Parallelschaltung erhöhen, was sich beispielsweise innerhalb eines Schwingkreises mittels veränderter Dämpfung feststellen ließe. In einem zweiten möglichen Korrosionszustand, in dem beispielsweise ein zweiter parallel geschalteter Widerstand durch Korrosion durchtrennt wurde, hat sich eine entsprechende zweite Erhöhung des Gesamtwiderstands ergeben, was wiederum die elektrischen Eigenschaften der Sensorikschaltung verändert. Die kann mit beliebig vielen Widerständen hochskaliert werden.

Mit anderen Worten ist mit dieser Parallelschaltung der elektrischen Widerstände ein Ausführungsbeispiel gegeben, bei welchem nicht nur der erste und der zweite Leitungsabschnitt, sondern auch zumindest ein korrosionsresistentes Überbrückungselement die elektrischen Eigenschaften der Sensorikschaltung mitbestimmt. Damit kann beispielsweise ein kontinuierlicher Zuwachs an Korrosion an dem entsprechenden zu überwachenden Bauteil nachgewiesen werden.

Mit anderen Worten ist es möglich, als korrosionssensitives Überbrückungselement mehrere Widerstände und Parallelschaltungen mit unterschiedlichen Materialdicken zu verwenden. Korrosion wird zunächst die Widerstände mit geringer Materialdicke inaktivieren. Ein verbleibender Widerstand, der entweder gegen Korrosion durch beispielsweise Lack geschützt wird oder der aus korrosionsresistentem Material besteht, kann letztlich die Funktion des RFID-Schwingkreises erhalten. Beispielsweise kann Gold und/oder Platin für die Widerstände, auch nur teilweise, verwendet werden.

Dabei können zumindest zwei verschiedene elektrische Widerstände unterschiedliche Materialdicken derart aufweisen, dass sie eine im Wesentlichen unterschiedliche Resistenz gegenüber Korrosion aufweisen.

Gemäß einem weiteren Ausführungsbeispiel der Erfindung ist ein Luftfahrzeug mit einer Korrosionsdetektionsvorrichtung gemäß einem der vorherigen Ausführungsbeispiele oder nachfolgenden Ausführungsbeispiele angegeben. Weiterhin ist es möglich, dass sich zumindest zwei dieser parallel geschalteter korrosionssensitiver Überbrückungselemente in einem Parameter unterscheiden, der ausgewählt ist aus der Gruppe bestehend aus elektrischer Widerstand, geometrischer Abmessung, Dicke, Material, zusätzlichen korrosionsresistenten Lackierungsschichten, und jede Kombination daraus.

Dabei sei in diesem und jedem anderen Ausführungsbeispiel darauf hingewiesen, dass das Überbrückungselement durch Korrosion nicht vollständig zerstört werden muss, um die erfindungsgemäße Wirkung zu erzielen, so dass auch nicht zwingend ein Kurzschluss aufgehoben werden muss. Eine Veränderung der elektrischen Leitfähigkeit kann es dem Nutzer ermöglichen, die Anwesenheit von Korrosion an dem zu überwachenden Bauteil zu detektieren.

Gemäß einem weiteren Ausführungsbeispiel der Erfindung kann mittels der oben beschriebenen Verwendung eines RFID-Schwingkreises die Identifikationsinformation der Sensorikschaltung an ein Auslesegerät gesendet werden, welches ein räumliches Lokalisieren des identifizierten Bauteils auf Basis der Identifikationsinformation zulässt.

Dadurch können korrodierte Bauteile kostengünstig, schnell und mit verringertem Messaufwand überprüft werden. Es können die Umgebungsbedingungen eiens hinsichtlich Korrosion zu überwachenden Bauteils mit der Erfindung überwacht werden.

### KURZE BESCHREIBUNG DER FIGUREN

Die Darstellungen in den Figuren sind schematisch und nicht maßstäblich.
Fig. 1 zeigt eine schematische, zweidimensionale Darstellung einer Korrosionsdetektionsvorrichtung gemäß einem Ausführungsbeispiel der Erfindung.
Fig. 2 zeigt eine schematische, zweidimensionale Darstellung einer Korrosionsdetektionsvorrichtung gemäß einem Ausführungsbeispiel der Erfindung.
Fig. 3 zeigt eine schematische, zweidimensionale Darstellung einer Korrosionsdetektionsvorrichtung gemäß einem Ausführungsbeispiel der Erfindung.
Fig. 4 zeigt eine schematische, zweidimensionale Darstellung einer Korrosionsdetektionsvorrichtung gemäß einem Ausführungsbeispiel der Erfindung.
Fig. 5 zeigt eine schematische, zweidimensionale Darstellung einer Korrosionsdetektionsvorrichtung.
Fig. 6 zeigt ein Luftfahrzeug mit einer Korrosionsdetektionsvorrichtung gemäß einem Ausführungsbeispiel der Erfindung.

Im Folgenden werden mit Verweis auf die Figuren bevorzugte Ausführungsbeispiele der vorliegenden Erfindung beschrieben.

In der folgenden Figurenbeschreibung werden für die gleichen oder ähnlichen Elemente die gleichen Bezugsziffern verwendet.

Die folgenden hier getroffenen Ausführungen gelten ebenfalls für ein Luftfahrzeug, welches eine Korrosionsdetektionsvorrichtung enthält, die ein Ausführungsbeispiel der vorliegenden Erfindung ist.

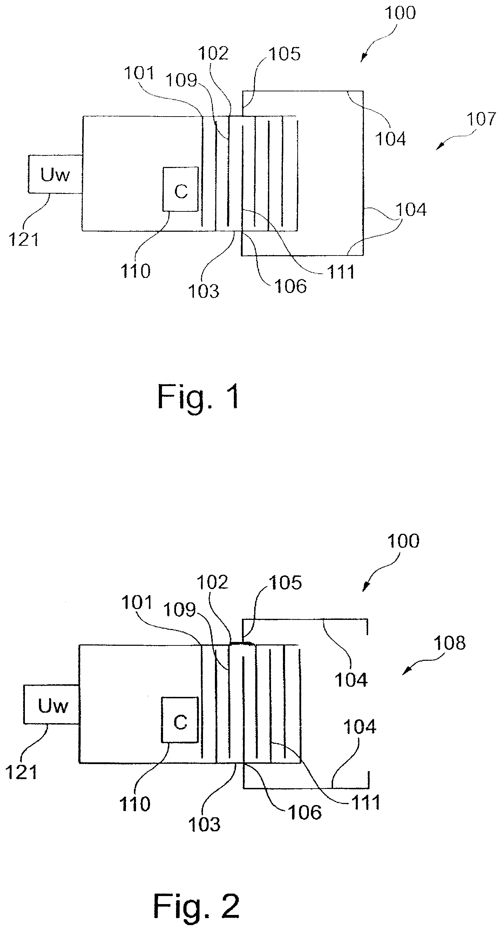

Fig. 1 zeigt eine Korrosionsdetektionsvorrichtung 100 zur permanenten und integralen Überwachung eines Korrosionszustandes an einem Bauteil, wobei die Korrosionsdetektionsvorrichtung eine Sensorikschaltung 101 zur Detektion von Korrosion an dem Bauteil aufweist. Die Sensorikschaltung weist einen ersten elektrischen Leitungsabschnitt 102 und einen zweiten elektrischen Leitungsabschnitt 103 auf. Dabei ist in diesem Ausführungsbeispiel der Erfindung ein Leitungsabschnitt als Elektrode 109 und 111 eines Kondensators 110 ausgeführt.

In diesem Ausführungsbeispiel der Fig. 1 ist der Kondensator als Interdigitalkondensator mit mehreren ineinander ragenden Fingern dargestellt. Weiterhin ist in der Sensorikschaltung ein korrosionssensitives Überbrückungselement 104 gezeigt, welches ein erstes Ende 105 und ein zweites Ende 106 aufweist. Weiterhin ist das erste Ende mit dem ersten Leitungsabschnitt 102 und das zweite Ende mit dem zweiten Leitungsabschnitt 103 in dem hier gezeigten Ausgangszustand 107 in elektrisch leitender Verbindung. Dabei beschreibt dieser Ausgangszustand die Situation, in welcher Korrosion noch nicht verursacht hat, dass die elektrisch leitende Verbindung durch Element 104 unterbrochen ist.

Charakteristisch für das erfindungsgemäße korrosionssensitive Überbrückungselement ist weiterhin, dass sich die Auswirkungen von Korrosion an dem Überbrückungselement und damit an dem zu überwachenden Bauteil kumulativ über die Zeit aufsummieren und somit eine integrale Korrosionsmessung über die Zeit möglich ist.

Im Vergleich zur Fig. 2, in welcher ein Korrosionszustand 108 beschrieben wird, zeigt Fig. 1 somit einen kurzgeschlossenen Interdigitalkondensator, welcher aufgrund des Kurzschlusses durch das korrosionssensitive Überbrückungselement nicht mittels angelegten Spannung durch die Spannungsquelle 121 in seiner Kapazität bestimmt werden kann.

Diese Kapazitätsbestimmung ist jedoch in dem darunter gezeigten Korrosionszustand 108 der Detektionsvorrichtung 100 in Fig. 2 gezeigt. Aufgrund von Korrosion ist das korrosionssensitive Überbrückungselement in einem Bereich am rechten Bildrand durchtrennt worden, weshalb eine elektrostatische Aufladung des Kondensators 110 ermöglicht wird. Seine Kapazität kann bestimmt werden.

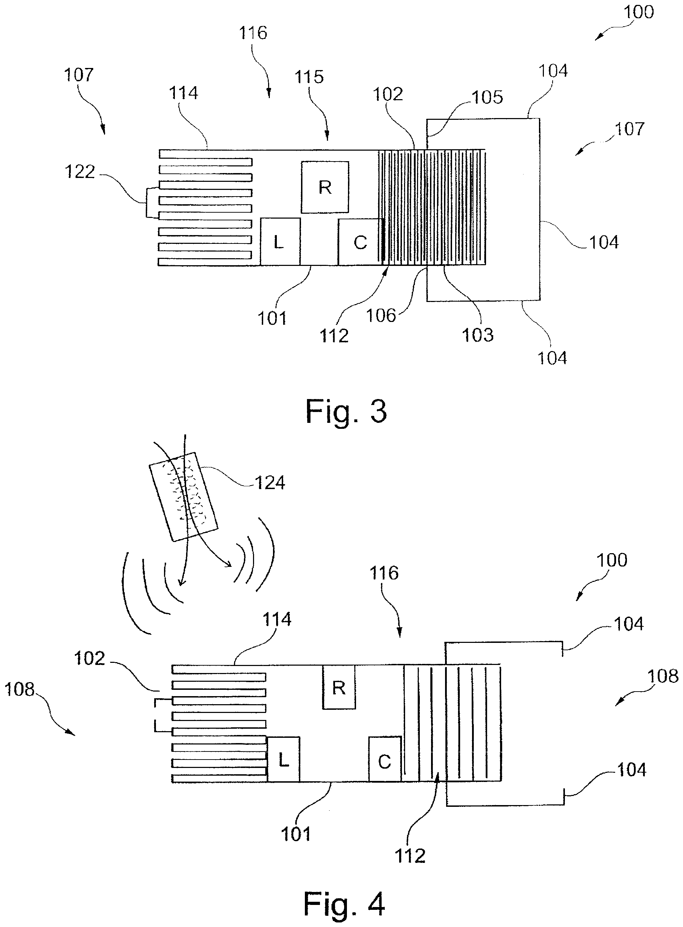

Die Fig. 3 und 4 beschreiben eine Detektionsvorrichtung 100, welche sich in Fig. 3 in dem Anfangszustand 107 und in Fig. 4 in dem Korrosionszustand 108 befindet. Dabei weist die Korrosionsdetektionsvorrichtung einen RFID-Schwingkreis 116 auf. Dabei zeigt Fig. 3 eine Sensorikschaltung 101 in einem ersten und zweiten Leitungsabschnitt 102 und 103. Der Interdigitalkondensator 112, der Teil des RFID-Schwingkreises ist, befindet sich in Fig. 3 in einem kurzgeschlossenen Zustand, da das korrosionssensitive Überbrückungselement 104 den elektrischen Kurzschluss herstellt. Dadurch wird der RFID-Schwingkreis in einen inaktiven Zustand versetzt und kann nicht von extern ausgelesen werden.

Die am linken Bildrand von Fig. 3 dargestellte Spule 114 kann zusätzlich zu der Überbrückung des Kondensators einen Verbindungsdraht 122 aufweisen, der einen elektrischen Kurzschluss zwischen verschiedenen Windungen der Spule 114 herstellt.

Erst nach entsprechend akkumulierten Umwelteinflüssen wie Feuchtigkeit und Temperatur kann die Korrosion den Kurzschluss mittels der korrosionssensitiven Überbrückungselemente 104 und 122 aufheben. Diese Situation ist in Fig. 4 dargestellt. Aufgrund der aufgehobenen Kurzschlüsse kann mittels eines RFID-Auslesegerätes 124 der Schwingkreis gegebenenfalls mit Energie versorgt und damit zur Aussendung einer entsprechenden Antwort angeregt werden. Mit anderen Worten ist im Falle einer Detektion einer Antwort eines solchen RFID-Schwingkreises sichergestellt, dass eine entsprechende Korrosion an der Sensorikschaltung und damit an dem zu überwachenden Bauteil (hier nicht gezeigt) stattgefunden hat. Dabei kann das korrosionssensitive Überbrückungselement beispielsweise aus dem Material gefertigt sein, aus welchem das zu untersuchende Bauteil besteht. Im Falle eines Luftfahrzeuges kann dies beispielsweise eine Aluminiumlegierung sein.

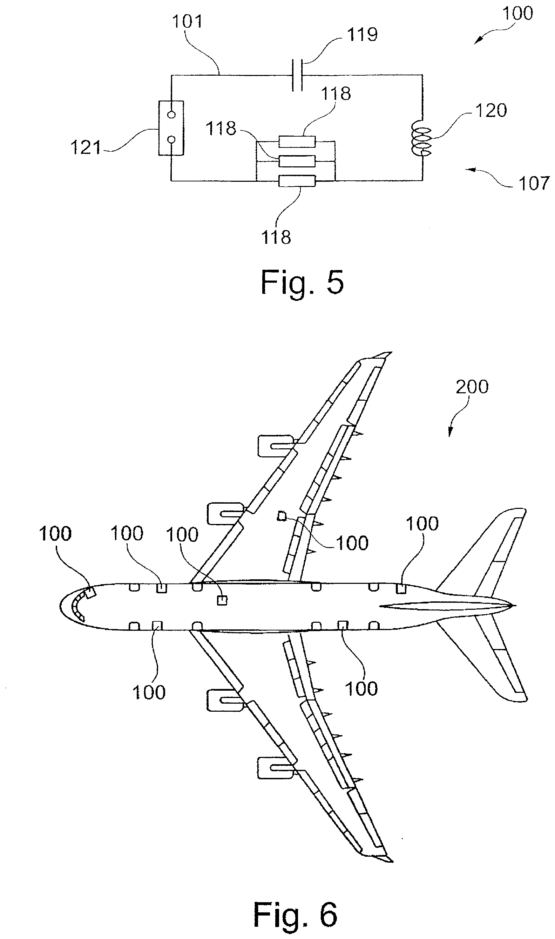

Fig. 5 zeigt eine nicht erfindungsgemäße Korrosionsdetektionsvorrichtung 100 mit einer Sensorikschaltung 101, die einen Kondensator 119 und eine Spule 120 aufweist. Dabei ist in diesem Ausführungsbeispiel der Ausgangszustand 107 gezeigt, bei welchem drei parallel geschaltete korrosionssensitive Überbrückungselemente 118 gezeigt sind. Diese drei parallelen Widerstände können beispielsweise eine unterschiedliche Materialdicke aufweisen. Dabei wird die Korrosion zunächst die Widerstände mit geringer Materialdicke inaktivieren. Ein verbleibender Widerstand, der entweder gegen Korrosion geschützt wird durch beispielsweise Lack oder aus korrosionsresistentem Material besteht, beispielsweise Gold oder Platin, oder auch eine Legierung daraus, erhält letztlich die Funktion dieses Schwingkreises. Dabei könne auch in diesem Schwingkreis der Fig. 5 zusätzlich weitere Komponenten eines RFID-Schwingkreises wie beispielsweise ein Speicher oder eine Antenne vorhanden sein. Diese Elemente sind jedoch in Fig. 5 nicht gezeigt.

Fig. 6 zeigt ein Luftfahrzeug 200, das in diesem Ausführungsbeispiel der Erfindung als Flugzeug ausgeführt ist, wobei das Flugzeug eine Vielzahl von Korrosionsdetektionsvorrichtungen an verschiedenen Orten aufweist. Dabei kann die erfindungsgemäße Korrosionsdetektionsvorrichtung vorzugsweise im Inneren des Flugzeuges also beispielsweise innerhalb der Kabine oder dem Frachtraum Anwendung finden.

## Patentansprüche

1. Korrosionsdetektionsvorrichtung (100) zur permanenten und integralen Überwachung eines Korrosionszustandes eines Bauteils, wobei die Korrosionsdetektionsvorrichtung aufweist:
eine Sensorikschaltung (101) zur Detektion von Korrosion an dem Bauteil,
wobei die Sensorikschaltung einen ersten elektrischen Leitungsabschnitt (102) und einen zweiten elektrischen Leitungsabschnitt (103) aufweist,
wobei die Sensorikschaltung ein korrosionssensitives Überbrückungselement (104) mit einem ersten Ende (105) und einem zweiten Ende (106) aufweist,
wobei das erste Ende mit dem ersten Leitungsabschnitt und das zweite Ende mit dem zweiten Leitungsabschnitt in einem Ausgangszustand (107) in elektrisch leitender Verbindung steht,
wobei das korrosionssensitive Überbrückungselement in dem Ausgangszustand eine erste elektrische Leitfähigkeit und in einem Korrosionszustand (108) eine zweite elektrische Leitfähigkeit aufweist, derart, dass mit der Sensorikschaltung auf Basis eines Wechsels von der ersten zur zweiten elektrischen Leitfähigkeit Korrosion detektierbar ist,
wobei der erste elektrische Leitungsabschnitt als eine erste Elektrode (109) eines Kondensators (110) und der zweite elektrische Leitungsabschnitt als eine zweite Elektrode (111) des Kondensators ausgeführt ist,
wobei der Kondensator ein Interdigitalkondensator (112) ist,
wobei das korrosionssensitive Überbrückungselement als Dünnschicht (113) zwischen zwei Elektroden des Interdigitalkondensators ausgeführt ist, und
wobei der Interdigitalkondensator im Ausgangszustand kurzgeschlossen ist.

2. Korrosionsdetektionsvorrichtung gemäß Anspruch 1, wobei die Korrosionsdetektionsvorrichtung weiterhin aufweist:
eine Auslesevorrichtung (115),
wobei die Auslesevorrichtung zur Messung elektrischer Eigenschaften einer Anordnung umfassend den ersten Leitungsabschnitt, den zweiten Leitungsabschnitt und das korrosionssensitive Überbrückungselement ausgeführt ist.

3. Korrosionsdetektionsvorrichtung gemäß einem der Ansprüche 1 und 2, wobei die Sensorikschaltung als RFID Schwingkreis (116) ausgeführt ist.

4. Korrosionsdetektionsvorrichtung gemäß Anspruch 3,
wobei der RFID Schwingkreis aufweist:
eine Antenne zum Senden und Empfangen von elektromagnetischen Signalen, und
einen analogen Schaltkreis mit einer elektrischen Kapazität und einer elektrischen Induktivität,
wobei das korrosionssensitive Überbrückungselement in dem Anfangszustand den RFID Schwingkreis elektrisch überbrückt.

5. Korrosionsdetektionsvorrichtung gemäß einem der Ansprüche 3 und 4
wobei die Sensorikschaltung derart ausgeführt ist, dass ein Auslesen ermöglicht wird, das ausgewählt ist aus der Gruppe bestehend aus gegenphasigem Reflektieren eines von einem Lesegerät (117) eingestrahlten Feldes, Schwächen eines von einem Lesegerät (117) eingestrahlten Feldes, Auslesen mittels Lastenmodualtion, und jede Kombination daraus.

6. Korrosionsdetektionsvorrichtung gemäß einem der Ansprüche 1 bis 5,
wobei die Sensorikschaltung eine Mehrzahl parallel geschalteter korrosionssensitiver Überbrückungselemente (118) aufweist,
wobei die Mehrzahl der parallel geschalteter korrosionssensitiver Überbrückungselemente derart zueinander dimensioniert sind, dass sie einer
vorgebbaren Charakteristik eines Korrosionszeitverlaufs entsprechen.

7. Luftfahrzeug (200) mit einer Korrosionsdetektionsvorrichtung gemäß einem der Ansprüche 1 bis 6.

## Claims

1. Corrosion detection device (100) for the permanent and integral monitoring of a corrosion status of a component, wherein the corrosion detection device has a sensory circuit (101) for the detection of corrosion on the component, wherein the sensory circuit has a first electrical conductor portion (102) and a second electrical conductor portion (103), wherein the sensory circuit has a corrosion-sensitive bridging element (104) with a first end (105) and a second end (106), wherein in an initial state (107) the first end is in electrically conductive connection with the first conductor portion and the second end is in electrically conductive connection with the second conductor portion, wherein the corrosion-sensitive bridging element has a first electrical conductivity in the initial state and has a second electrical conductivity in a corrosion state (108) such that corrosion can be detected with the sensory circuit on the basis of a change from the first to the second electrical conductivity, wherein the first electrical conductor portion is executed as a first electrode (109) of a capacitor (110) and the second electrical conductor portion is executed as a second electrode (111) of the capacitor, wherein the capacitor is an interdigital capacitor (112), wherein the corrosion-sensitive bridging element is executed as a thin layer (113) between two electrodes of the interdigital capacitor, and wherein the interdigital capacitor is short-circuited in the initial state.

2. Corrosion detection device according to claim 1, wherein the corrosion detection device also has a readout device (115), wherein the readout device is provided for the measurement of electrical properties of an arrangement comprising the first conductor portion, the second conductor portion and the corrosion-sensitive bridging element.

3. Corrosion detection device according to any one of claims 1 and 2, wherein the sensory circuit is provided as an RFID resonant circuit (116).

4. Corrosion detection device according to claim 3, wherein the RFID resonant circuit has an antenna for sending and receiving electromagnetic signals, and an analogue circuit with an electrical capacity and electrical inductance, wherein in the initial state the corrosion-sensitive bridging element bridges the RFID resonant circuit electrically.

5. Corrosion detection device according to any one of claims 3 and 4, wherein the sensory circuit is provided such that readout is possible, said readout being selected from the group consisting of the anti-phase reflection of a field irradiated by a read device (117), weaknesses of a field irradiated by a read device (117), readout by means of load modulation, and any combination thereof.

6. Corrosion detection device according to any one of claims 1 to 5, wherein the sensory circuit has a plurality of corrosion-sensitive bridging elements (118) connected in parallel, wherein the plurality of corrosion-sensitive bridging elements connected in parallel are dimensioned in such a way in respect of one another that they correspond to a pre-definable characteristic of a corrosion time lapse.

7. Aircraft (200) with a corrosion detection device according to any one of claims 1 to 6.

## Revendications

1. Dispositif de détection de corrosion (100) pour surveiller en permanence et de manière intégrale un état de corrosion d'un élément, dans lequel le dispositif de détection de corrosion présente :
un circuit de détection (101) pour détecter une corrosion sur l'élément,
dans lequel le circuit de détection présente une première section de ligne électrique (102) et une seconde section de ligne électrique (103),
dans lequel le circuit de détection présente un élément de pontage sensible à la corrosion (104) avec une première extrémité (105) et une seconde extrémité (106),
dans lequel la première extrémité est dans un état initial (107) en liaison électriquement conductrice avec la première section de ligne et la seconde extrémité avec la seconde section de ligne,
dans lequel l'élément de pontage sensible à la corrosion présente dans l'état initial une première conductivité électrique et dans un état de corrosion (108) une seconde conductivité électrique, de telle sorte que le circuit de détection permet de détecter une corrosion sur la base d'un changement de la première conductivité électrique vers la seconde conductivité électrique,
dans lequel la première section de ligne électrique est réalisée sous la forme d'une première électrode (109) d'un condensateur (110) et la seconde section de ligne électrique sous la forme d'une seconde électrode (111) du condensateur,
dans lequel le condensateur est un condensateur interdigital (112),
dans lequel l'élément de pontage sensible à la corrosion est réalisé sous la forme d'une couche mince (113) entre deux électrodes du condensateur interdigital, et
dans lequel le condensateur interdigital est en court-circuit dans l'état initial.

2. Dispositif de détection de corrosion selon la revendication 1, dans lequel le dispositif de détection de corrosion présente en outre :
un moyen de lecture (115),
dans lequel le moyen de lecture est réalisé pour mesurer des propriétés électriques d'un agencement comprenant la première section de ligne, la seconde section de ligne et l'élément de pontage sensible à la corrosion.

3. Dispositif de détection de corrosion selon une des revendications 1 et 2, dans lequel le circuit de détection est réalisé sous la forme d'un circuit résonnant RFID (116).

4. Dispositif de détection de corrosion selon la revendication 3, dans lequel le circuit résonnant RFID présente :
une antenne pour envoyer et recevoir des signaux électromagnétiques, et
un circuit analogique avec une capacité électrique et une inductance électrique,
dans lequel l'élément de pontage sensible à la corrosion ponte électriquement le circuit résonnant RFID dans l'état initial.

5. Dispositif de détection de corrosion selon une des revendications 3 et 4, dans lequel le circuit de détection est réalisé de telle sorte qu'une lecture est possible, choisie dans le groupe comstitué d'une réflexion en opposition de phase d'un champ irradié par un appareil de lecture (117), d'un affaiblissement d'un champ irradié par un appareil de lecture (117), d'une lecture au moyen d'une modulation de charges, et d'une combinaison de ceux-ci.

6. Dispositif de détection de corrosion selon une des revendications 1 à 5,
dans lequel le circuit de détection présente une pluralité d'éléments de pontage sensibles à la corrosion (118) connectés en parallèle,
dans lequel la pluralité d'éléments de pontage sensibles à la corrosion connectés en parallèle sont dimensionnés les uns par rapport aux autres de telle sorte qu'ils correspondent à une caractéristique prédéfinissable d'une variation dans le temps de la corrosion.

7. Aéronef (200) comprenant un dispositif de détection de corrosion selon une des revendications 1 à 6.
